# EUROPEAN PATENT APPLICATION

(11) **EP 1 601 100 A1**
(43) Date of publication of application: **30.11.2005**
(21) Application number: 04425383.9
(22) Date of filing: 27.05.2004
(51) Int. Cl.: H03F 3/45

(54) **Transistor amplifying stage**

(71) Applicant: STMicroelectronics S.r.l., 20041 Agrate Brianza (Milano) (IT)
(72) Inventor: Filoramo, Pietro, 96100 Siracusa (IT); Cavallaro, Alberto Giuseppe, 95125 Catania (IT)
(74) Representative: Mittler, Enrico

(57) **Abstract**

Herein described is an amplifying stage comprising a first circuit part (1) and a second circuit part (2). The first circuit part (1) is positioned between a first (Vdd) and a second reference voltage and comprises at least a first transistor (Ma1....Man) having a first non-drivable terminal connected with current supplying means (Ibias) and at least a second transistor (Mt1) having a first non-drivable terminal connected with a second non-drivable terminal of the at least a first transistor (Ma1....Man); the current supplying means (Ibias) are connected to said first reference voltage (Vdd). The second circuit part (2) is connected by circuit to the first circuit part (1) and is fed by a current (It2) proportional to the current supplied by the current supplying means (Ibias). The second circuit part (2) has at least one input terminal and is connected to a load (LOAD). The first circuit part (1) comprises means (3) for connecting said first non-drivable terminal of the at least a first transistor (Ma1....Man) with the drivable terminal of the at least a second transistor (Mt1) and said connection means (3) are suitable for imposing the current that passes through said at least a second transistor (Mt1) to be the same as current (Ibias) supplied by said current supplying means and the voltage (Vp) between said first non-drivable terminal of the at least a first transistor (Ma1....Man) and ground is greater than the saturation voltage (Vds-sat) between the non-drivable terminals of said at least a first transistor (Ma1....Man). At the drivable terminal of the at least a first transistor (Ma1....Man) and at the at least one input terminal of the second circuit part (2) the same at least one input signal (Vin1....Vinn).

## Description

The present invention refers to a transistor amplifying stage.

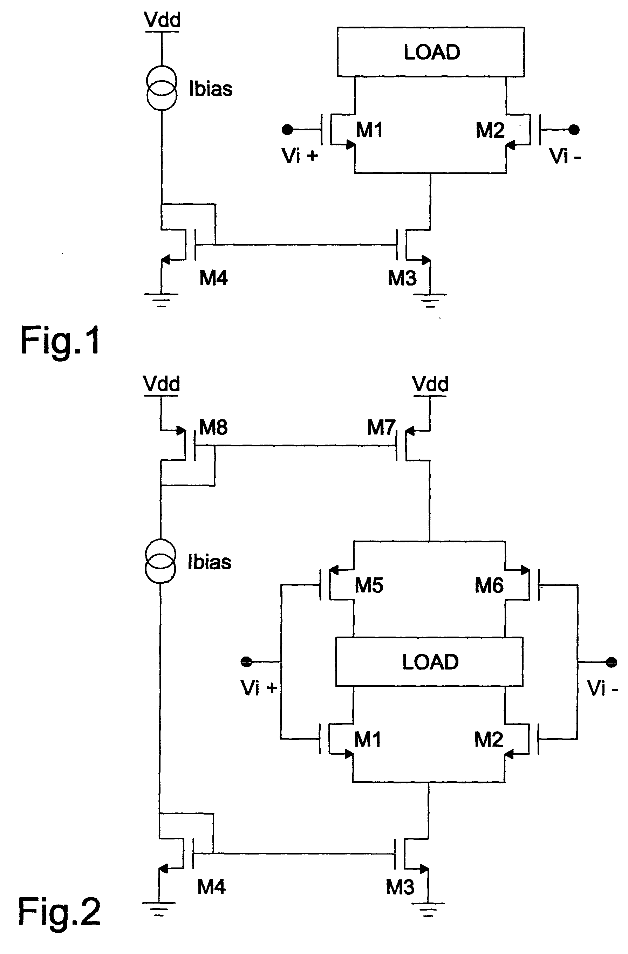

Transistor amplifiers are generally known in the state of the technique. An amplifier of this type is shown in Figure 1; the amplifier comprises an MOS transistor pair M1, M2 in differential configuration that are fed by a bias current Ibias conveyed by means of a mirror made up of transistors M4, M3. The input signal is the differential signal Vi+ and Vi- applied to the gate terminals of the respective transistors M1 and M2; the drain terminals of the transistors M1 and M2 are connected to a load LOAD. Said amplifier has the disadvantage of a low volume range input, in fact in order that the current mirror M3, M4 operates correctly the voltage has to be Vi>Vds-sat3+Vgs1 where Vds-sat3 is the saturation voltage of the transistor M3 and Vgs1 is the voltage between the gate and source terminals of the transistor M1. So as to lessen the term Vds-sat3+Vgs1 the transistors M1 and M2 can be dimensioned in weak inversion region, that is in under-threshold region, to make the voltage Vgs1 nearly the same as the threshold voltage Vth. With the MOS transistors of the latest generation, the threshold voltage is between 250mV and 400mV. To ensure good accuracy of the mirror M3, M4 the voltage Vds-sat3 has to be kept at sufficiently high values, that is between 200mV and 350mV. In this manner said amplifier can be used for input voltages that exceed 450mV.

An amplifier circuit that has a greater input dynamic is shown in Figure 2. Said amplifier comprises in relation to the amplifier of Figure 1 another current mirror made by PMOS transistor M7, M8 and another PMOS transistor differential pair M5, M6 having the drain terminals connected with the load LOAD and the source terminals connected to the source terminal of the transistor M7. The input signals Vi+ and Vi- are connected to the gate terminals of the respective transistors M1, M5 and M2, M6. In this manner for any value of the common mode input signal Vi+, Vi- the amplifier of Figure 2 works correctly. The main disadvantage lies in the discontinuity of the amplification gain due to the use of two different transconductances for the PMOS transistors M5, M6 and the NMOS transistors M1, M2; in fact it is generally known that the transconductance of the PMOS transistor is lower than the transconductance of the NMOS transistor and in addition an operating region of the circuit is present in which both the NMOS and PMOS transistors are active with a consequent significant increase of the overall transconductance. To these disadvantages are added the disadvantages of a greater occupation of the area in the silicon blank where said circuit will be implemented and the greater dissipation of current.

In view of the state of the technique described, the object of the present invention is to provide an amplifier that presents a wide input volume range.

In accordance with the present invention, this object is achieved by means of an amplifying stage comprising a first circuit part and a second circuit part, said first circuit part being positioned between a first and a second reference voltage, said first circuit part comprising at least a first transistor having a first non-drivable terminal connected with current supplying means and at least a second transistor having a first non-drivable terminal connected with a second non-drivable terminal of the at least first transistor, said current supplying means being connected to said first reference voltage, said second circuit part being connected through the circuit to said first circuit part and being powered by a current proportional to the current supplied by said current supplying means, said second circuit part having at least one input terminal and being connected to a load, characterised in that said first circuit part comprises connection means of said first non-drivable terminal of the at least one first transistor with the drivable terminal of the at least a second transistor, said connection means being suitable for causing the current passing through said at least a second transistor to be equal to the current supplied by said current supplying means and the voltage between said first non-drivable terminal of the at least a first transistor and ground to be greater than the saturation voltage between the non-drivable terminals of said at least first transistor, and that the same at least one input signal is applied on the drivable terminal of the at least a first transistor and to the at least an input terminal of the second circuit part.

The characteristics and the advantages of the present invention will appear evident from the following detailed description of an embodiment thereof, illustrated as non-limiting example in the enclosed drawings, in which:
Figure 1 is a circuit diagram of a transistor amplifying stage of the type known;
Figure 2 is another circuit diagram of a transistor amplifying stage according to the known art;
Figure 3 is a circuit diagram of a transistor amplifying stage according to the present invention;
Figure 4 is a circuit diagram of an implementation of the stage of Figure 3;
Figure 5 is a diagram of the gain in decibels of the circuit of Figure 4;
Figure 6 is a diagram of some currents of the circuit of Figure 4.

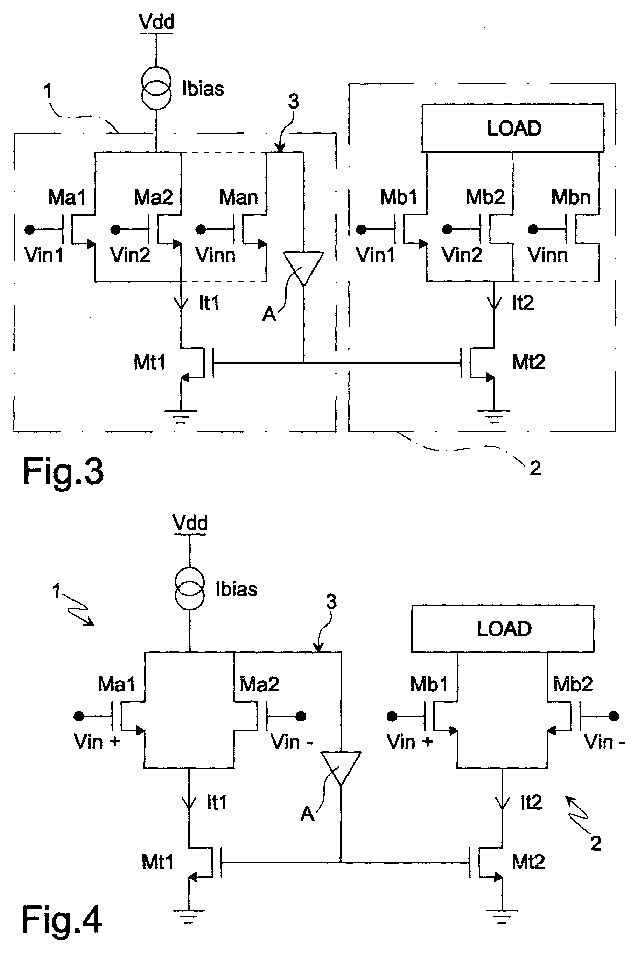

With reference to Figure 3 a transistor amplifying stage is shown, preferably a MOS transistor, comprising a first circuit part or master 1 and a second circuit part or slave 2. The first circuit part 1 comprises at least one first transistor Ma1 having a non-drivable terminal, the drain terminal, connected with a current generator Ibias and at least a second transistor Mt1 having a non-drivable terminal, the drain terminal, connected with another non-drivable terminal, the source terminal, of the at least one first transistor Ma1. Preferably the first circuit part 1 comprises a plurality of transistors Ma1....Man having the drain and the source terminals in common. The current generator Ibias is connected to a supply voltage Vdd.

The second circuit part or slave 2 comprises at least a third transistor Mt2 having the drivable terminal, the gate terminal, connected with the drivable terminal (that is the gate terminal) of the second transistor Mt1 and at least a fourth transistor Mb1 having a non-drivable terminal, the source terminal, connected with a non-drivable terminal, the drain terminal, of the at least a third transistor Mt2 and another non-drivable terminal, the drain terminal, connected to a load LOAD. Preferably said at least a fourth transistor comprises a plurality of transistors Mb1....Mbn having the source and drain terminals in common. The gate terminals of the transistors Ma1..Man and of the transistors Mb1...Mbn are connected to the respective input signals Vin1....Vinn.

The first circuit part 1 comprises connection means 3 of the drain terminal of the plurality of transistors Ma1..Man with the gate terminal of the transistor Mt1. Said connection means 3 can consist of a simple electrical connection line or they can also comprise an amplifier A with high input impedance or with negligible input current. Said connection means are suitable for imposing the current It1 that passes through the transistor Mt1 is the same as current supplied by the current generator Ibias. In fact the negative feedback, in the case in which the two currents are not equal and therefore the voltage on the node P tends to positive or negative supply, reacts by means of the means 3 on the gate of the transistor Mt1 to restore the condition of equilibrium.

The connection means A are suitable for making sure that the voltage between the drain terminal in common of the transistors Ma1..Man and ground is greater than the saturation voltage Vds between the drain and the source terminals of the same transistors Ma1..Man of at least a hundred-odd millivolts.

The first circuit part 1 presents three operating regions upon variation of the input voltage Vini in which one of the voltages from Vinl to Vinn is indicated with Vini.

In the first operating region there is Vgs-ai<Vini<Va, where Vgs-ai is the voltage between gate and source of the generic transistor Mai with i=1...n and Va=Vgs-ai+Vds-sat-t1 where Vds-sat-t1 is the saturation voltage of the transistor Mt1. In said first region the transistor Mai operates in saturation region and the transistor Mt1 operates in triode region.

In the second operating region Va<Vini<Vb where Vb indicates a voltage that depends on the circuit typology of the amplifier A used. In the case in which the amplifier has a unitary gain or the drain terminal of the transistor Mai is directly connected to the gate terminal of the transistor Mt1 Vb=Vgst1+Vth where Vgstl is the voltage between the gate terminals and source of the transistor Mt1 and Vth is the threshold voltage of the generic MOS transistor. In said second operating region both the transistors Mai and Mt1 operate in saturation region.

In the third operating region Vini>Vb; in these conditions the transistor Mai operates in triode region while the transistor Mt1 operates in saturation region.

The second circuit part 2 is made in such a way that it is a scaled copy of the first circuit part 1 by means of a form factor y that is the ratio between the form factors W/L of the transistor Mbi and of the transistor Mai (that is equal to the ratio between the form factors W/L of the transistor Mt2 and of the transistor Mtl) therefore It2= γ*Ibias where It2 is the drain current of the transistor Mt2. Therefore while the first circuit part 1 is made in such a way that it sets the input current to the second circuit part 2 and the latter represents the amplifying device of the whole circuit of Figure 3.

The operation of the amplifier A is to raise the static precision. In fact the loop gain T of the first circuit part 1 is *T* = *gt*1 × *r* × *G* where gtl is the transconductance of the transistor Mt1, r is the overall dynamic resistance seen at the node P and G is the linear gain of the amplifier A.

Figure 4 shows a circuit implementation of the apparatus shown in Figure 3 where only two transistors Ma1 and Ma2 are provided for the first circuit part 1 and only two transistors Mb1 and Mb2 for the second circuit part 2. The transistors Ma1, mb1 and Ma2, Mb2 have the respective input signals Vin+ and Vin-.

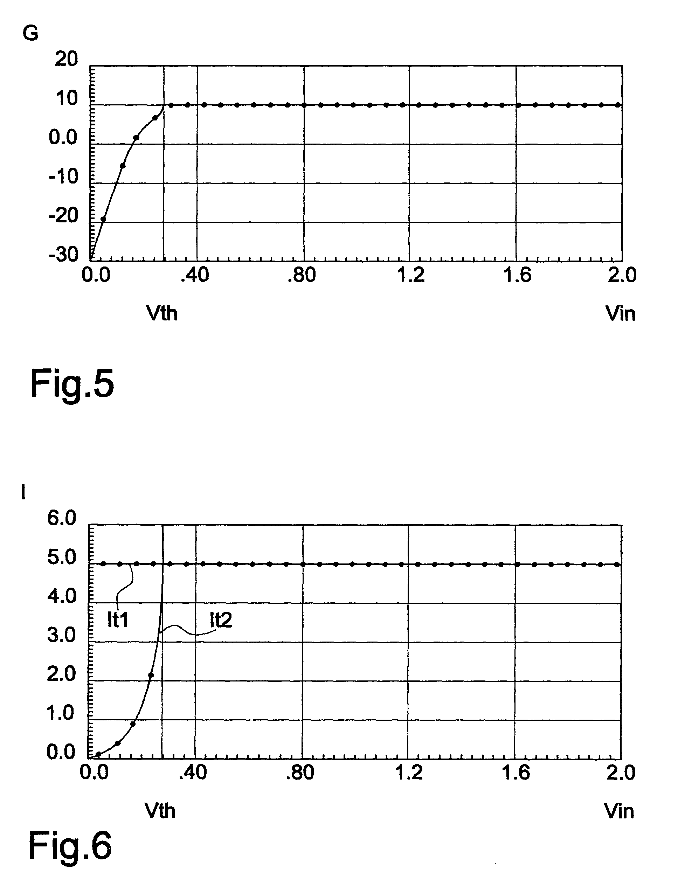

Figure 5 shows the gain in decibels upon variation of the input voltage for the circuit of Figure 4 assuming Vth=272mV and assuming that the voltage Vgs-a1=Vgs-a2 is nearly the same as the voltage Vth. From the diagram of Figure 5 it can be seen that amplifying stage proposed has an wider input volume range than the known amplifying stages and it does not present discontinuity of gain.

Figure 6 shows the path of the currents It1 and It2 upon variation of the input voltage for the circuit of Figure 4.

In alternative to the use of only MOS transistors bipolar transistors can be used for the transistors Ma1....Man and Mb1....Mbn; the transistors Mt1 and Mt2 remain MOS transistors.

The amplifying stage of Figure 3 is particularly suitable for operating at low supply voltages, for example with Vdd=1V or Vdd=1,5V.

## Claims

1. Amplifying stage comprising a first circuit part (1) and a second circuit part (2), said first circuit part (1) being disposed between a first (Vdd) and a second reference voltage, said first circuit part (1) comprising at least a first transistor (Ma1....Man) having a first non-drivable terminal connected with current supplying means (Ibias) and at least a second transistor (Mt1) having a first non-drivable terminal connected with a second non-drivable terminal of the at least a first transistor (Ma1....Man), said current supplying means (Ibias) being connected to said first reference voltage (Vdd), said second circuit part (2) being connected by circuit to said first circuit part (1) and being fed by a current (It2) proportional to the current supplied by said current supplying means (Ibias), said second circuit part (2) having at least one input terminal and being connected to a load (LOAD), **characterised in that** said first circuit part (1) comprises means (3) for connecting said first non-drivable terminal of the at least a first transistor (Ma1....Man) with the drivable terminal of the at least a second transistor (Mt1), said connection means (3) being suitable for imposing the current that passes through said at least a second transistor (Mt1) to be the same as current (Ibias) supplied by said current supplying means and the voltage (Vp) between said first non-drivable terminal of the at least a first transistor (Ma1....Man) and ground to be greater than the saturation voltage (Vds-sat) between the non-drivable terminals of said at least a first transistor (Ma1....Man), and **in that** at the drivable terminal of the at least a first transistor (Ma1....Man) and at the at least one input terminal of the second circuit part (2) the same at least one input signal (Vin1....Vinn) is applied.

2. Amplifying stage according to claim 1, **characterised in that** said second circuit part (2) comprises at least another transistor (Mt2) having the drivable terminal connected with the drivable terminal of the second transistor (Mt1) and at least another transistor (Mb1....Mbn) having a non-drivable terminal connected with a non-drivable terminal of the at least another transistor (Mt2) and another non-drivable terminal connected to a load (LOAD).

3. Amplifying stage according to claim 2, **characterised in that** said at least a first transistor (Ma1....Man) is made up of a differential transistor pair (Ma1, Ma2) having respectively a first (Vin+) and a second (Vin-) input signal and said at least another transistor is made up of a differential transistor pair (Mb1, Mb2) having respectively said first (Vin+) and said second (Vin-) input signal.

4. Amplifying stage according to claim 1, **characterised in that** said transistors are MOS transistors.

5. Amplifying stage according to claim 1, **characterised in that** said input signal (Vin1...Vinn) is a radio-frequency signal.

6. Amplifying stage according to claim 1, **characterised in that** said connection means (3) comprise an electrical connection line.

7. Amplifying stage according to claim 1, **characterised in that** said connection means (3) comprise an amplifier with high input impedance (A).

8. Amplifying stage according to claim 1, **characterised in that** the value of said at least one input signal (Vin1...Vinn) is greater than the voltage between the drivable terminal and said other non-drivable terminal of the first transistor (Ma1....Man).

9. Amplifying stage according to claim 1, **characterised in that** said at least a first transistor (Ma1....Man) comprises a plurality of transistors.

10. Amplifying stage according to claim 3, **characterised in that** said at least another transistor (Mb1....Mbn) comprises a plurality of transistors.

11. Amplifying stage according to claim 1, **characterised in that** said at least a second transistor (Mt1) has a second non-drivable terminal connected to ground.

12. Amplifying stage according to claim 3, **characterised in that** said other transistor (Mt2) has another non-drivable terminal connected to ground.

13. Amplifying stage according to claim 1, **characterised in that** the voltage (Vp) between said non-drivable terminal of the at least a first transistor (Ma1....Man) and ground is greater than at least a hundred-odd millivolts compared to the saturation voltage (Vds-sat) between the non-drivable terminals of said at least a first transistor (Ma1....Man).
